# EUROPÄISCHE PATENTSCHRIFT

(11) **EP 1 428 225 B1**
(45) Veröffentlichungstag und Bekanntmachung des Hinweises auf die Patenterteilung: **07.03.2007**
(21) Anmeldenummer: 02754917.9
(22) Anmeldetag: 19.07.2002
(51) Int. Cl.: G11C 29/00, G11C 7/10, H03M 13/09

(54) **KONZEPT ZUR SICHEREN DATENKOMMUNIKATION ZWISCHEN ELEKTRONISCHEN BAUSTEINEN**
CONCEPT FOR RELIABLE DATA TRANSMISSION BETWEEN ELECTRONIC MODULES
CONCEPT PERMETTANT DE TRANSMETTRE DES DONNEES DE MANIERE FIABLE ENTRE DES MODULES ELECTRONIQUES

(30) Priorität: 17.09.2001 DE 10145722
(43) Veröffentlichungstag der Anmeldung: 16.06.2004
(73) Patentinhaber: Infineon Technologies AG, 81669 München (DE)
(72) Erfinder: POECHMUELLER, Peter, 82008 Unterhaching (DE)
(74) Vertreter: Schoppe, Fritz
(86) Internationale Anmeldenummer: PCT/EP2002/008091
(87) Internationale Veröffentlichungsnummer: WO 2003/025950

(56) Entgegenhaltungen:
- VICTOR B: "Data Encoding to Prevent Crosstalk Delay" WEBSITE, 27. Februar 2001 (2001-02-27), Seiten 1-64, XP002245243 INTERNET
- FAVALLI M ET AL: "Optimization of error detecting codes for the detection of crosstalk originated errors" PROCEEDINGS DESIGN, AUTOMATION AND TEST IN EUROPE - IEEE COMP. SOCIETY, 13. März 2001 (2001-03-13), - 16. März 2001 (2001-03-16) Seiten 290-296, XP010538206 LOS ALAMITOS, USA

## Beschreibung

Die vorliegende Erfindung bezieht sich im allgemeinen auf eine Datenkommunikation zwischen elektronischen Bausteinen und insbesondere auf ein Konzept, um eine Datenkommunikation zwischen elektronischen Bausteinen auch bei hohen Taktfrequenzen über einen Datenbus sicher und zuverlässig gewährleisten zu können.

Bei heutigen elektronischen Systemen, wie beispielsweise bei einem Rechnersystem, sind vor allem das Speichersystem und die Verbindungsstrukturen, d. h. die Datenbusse, über die die elektronischen Bausteine mit den Zusatzkomponenten, wie z. B. mit Speicherbausteinen, kommunizieren, von großer Bedeutung, da sie die Leistungsfähigkeit des elektronischen Gesamtsystems in hohem Maße mitbestimmen. Ein wichtiges Leistungsmerkmal von Datenbussen ist dabei deren Übertragungsrate, mit der die Datensignale zwischen den kommunizierenden elektronischen Bausteinen über die Datenbusse übertragen werden. Dabei ergibt sich die maximale Übertragungsrate aus der Bustaktfrequenz, der Anzahl der Bustakte pro Datentransfer und der Anzahl der entsprechend der Busbreite pro Transfer übertragenen Bytes. Eine Leistungssteigerung der Datenübertragung über einen Datenbus wird somit im allgemeinen über eine Erhöhung der Bustaktfrequenz oder über eine Vergrößerung der Busbreite erreicht.

So hat sich beispielsweise bei DRAMs (Dynamic Random Access Memory = dynamischer Speicher mit wahlfreiem Zugriff) die Bustaktfrequenz für den Datenbus in den letzten sieben Jahren (bis 2001) von ca. 20 MHz auf 400 MHz gesteigert. Daher wird es zukünftig bei schnelleren und komplexeren elektronischen Systemen immer bedeutender werden, daß die einzelnen Systemkomponenten und Bausteine mit immer höheren Frequenzen und über immer breitere Datenbusse sicher und zuverlässig miteinander kommunizieren können.

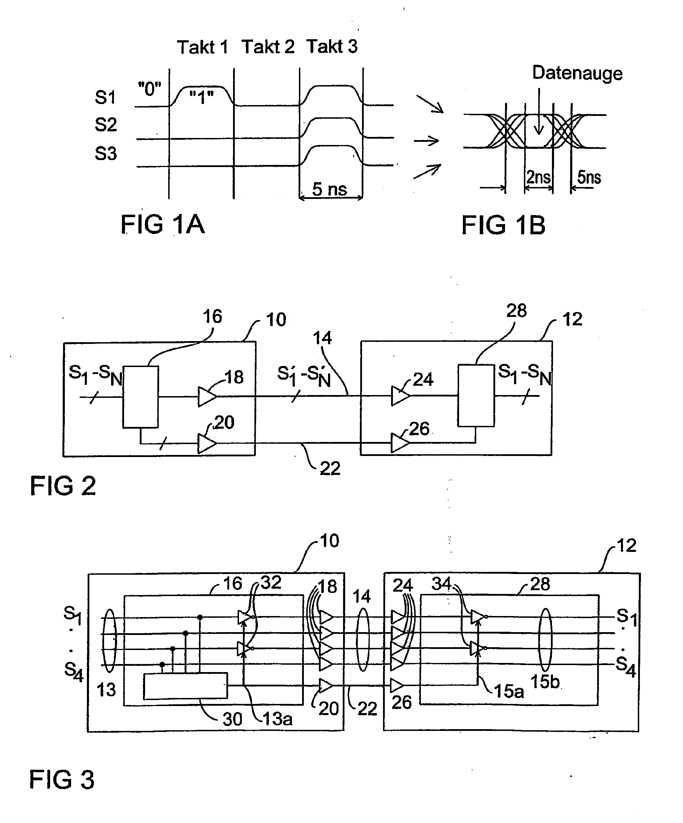

Um die Problematik der Datenkommunikation über einen parallelen Datenbus zu verdeutlichen, wird nun auf Fig. 1a Bezug genommen, in der beispielhaft unterschiedliche Bit- bzw. Datensignale S1 - S3 über einen Zeitraum von drei Taktzyklen dargestellt sind, die zwischen zwei elektronischen Bausteinen über einen parallelen Datenbus übertragen werden. Wie es in Fig. 1a dargestellt ist, wechselt im ersten Taktzyklus nur eines der Datensignale, d. h. das Signal S1, seinen Zustand von einem logischen Wert "0" auf einen logischen Wert "1", wohingegen im dritten Taktzyklus alle drei Datensignale S1 - S3 gleichzeitig von dem logischen Wert "0" auf den logischen Signalwert "1" wechseln.

Wenn ein Großteil der Signalwerte von einem Datenwort zu dem nächsten gleichzeitig wechseln, ist in der Praxis bei einer Datenübertragung über einen Datenbus zu beobachten, daß unterschiedliche Verzögerungen in der Anstiegszeit der einzelnen Signalflanken der Datensignale auf den einzelnen Busleitungen des Datenbusses auftreten. Der Grund für diese unterschiedlichen Verzögerungen bzw. Signalveränderungen in dem Signalverlauf liegt vor allem darin, daß, wie in dem letzten in Fig. 1a dargestellten Fall dargestellt, zahlreiche Signalwerte (hier alle Signalwerte) gleichzeitig in die gleiche Richtung geschaltet werden, so daß besonders viel Strom von den elektronischen Bausteinen zur Versorgung der zugeordneten Ausgangstreiber für die einzelnen Busleitungen des Datenbusses zur Verfügung gestellt werden muß. Dies führt jedoch aufgrund von unvermeidbaren parasitären Effekten, wie z. B. Leitungsbahnwiderständen und Induktivitäten, zu bausteininternen Spannungseinbrüchen der Versorgungsspannung in dem elektronischen Baustein, wodurch dessen Ausgangssignal und damit das zu übertragende Datensignal des sendenden elektronischen Bausteins maßgeblich beeinträchtigt werden kann.

Fig. 1b zeigt nun eine Darstellung, die sich theoretisch ergibt, wenn zahlreiche Einzeltaktsignalwerte von vielen Signalen über viele Taktzyklen, die mit Zufallsdaten betrieben werden, einander überlagert dargestellt werden. Durch diese in Fig. 1b dargestellte "Überlagerung" ergibt sich ein sogenanntes "Datenauge". Dieses resultierende Datenauge ist nun ein Indikator für die Signalqualität bei der Datenübertragung, d. h. das resultierende Datenauge gibt an, in welchem Zeitraum, auf den Taktzyklus bezogen, alle Signalwerte, die über den Datenbus übertragen werden, stabil sind, d. h. in welchem Zeitraum ein die Daten empfangender elektronischer Baustein die Eingangssignale an seinen Eingängen bewerten kann, da ansonsten unter Umständen ein falscher Signalwert ausgelesen bzw. interpretiert werden würde. So sollte das resultierende Datenauge im "Idealfall" eigentlich möglichst rechteckig sein, d.h. den idealen Rechteckverlauf der zu übertragenden Datensignale wiedergeben.

In dem in Fig. 1a und 1b dargestellten "realen" Beispiel beträgt ein Taktzyklus 5 ns, wobei sich jedoch durch die oben beschriebenen störenden Effekte das resultierende Datenauge auf eine effektive Breite, die letztendlich zur Datenauswertung der übertragenen Signaldaten zur Verfügung steht, beispielsweise auf eine Breite von etwa 2 ns verringern kann.

Dies stellt insbesondere für zukünftig zu erwartende, komplexe elektronische Systeme ein immer bedeutenderes Problem dar, da bei erhöhten Taktfrequenzen und bei größeren Busbreiten das resultierende Datenauge möglicherweise ganz verschwinden kann, so daß keine zuverlässige Signalübertragung über den Datenbus zwischen zwei elektronischen Bausteinen mehr möglich ist. Dies hat schließlich zur Folge, daß eine erwünschte und erforderliche Erhöhung der Taktfrequenz und der Bit-Breite der Datensignale aufgrund der genannten Probleme für zukünftige elektronische Systeme nicht mehr realisiert werden kann und somit die Systemgrenzen elektronischer Systeme bald erreicht sein werden.

Außerdem ist zu beachten, daß sich das resultierende Datenauge in einem elektronischen System auch durch Effekte wie Signalleitungskopplungen, Designunsymmetrien auf Sender- und Empfängerseite, usw. verringert. Damit tragen diese Effekte in elektronischen System weiter zu einer Beeinträchtigung der Datenübertragung bei.

Wie im vorhergehenden dargestellt wurde, handelt es sich also bei der wesentlichen Komponente, die zu einer Verringerung der effektiven Breite des resultierenden Datenauges bei einer Datenübertragung führt, vor allem um das gleichzeitige Schalten identischer Signalwerte, was in den elektronischen Bausteinen, die miteinander kommunizieren, zu internen Versorgungsspannungseinbrüchen führt. Dieser Effekt wird im folgenden als synchrones Schaltrauschen "SSN" (SSN = Synchronous Switching Noise) bezeichnet.

Bislang wurde das synchrone Schaltrauschen SSN nur durch allgemeine schaltungstechnische Maßnahmen bekämpft, indem möglichst gute und voneinander unabhängige Spannungsversorgungen der einzelnen Ausgangssignaltreiber der elektronischen Bausteine auf einem elektronischen Halbleiterbaustein vorgesehen wurden. Allerdings stoßen diese Verfahren mittlerweile an technische Grenzen und können derzeit nicht mehr bzw. nur noch mit einem sehr hohen Aufwand verbessert werden.

Die wissenschftliche Veröffentlichung "Data Encoding to Prevent Crosstalk Delay" von Bret Viktor beschäftigt sich mit der Datencodierung zur Verhinderung einer Nebensprechverzögerung, wobei dargestellt ist, daß die kapazitive Kopplung zwischen On-Chip-Verdrahtungen immer signifikanter wird, da sich die Taktgeschwindigkeiten erhöhen und sich die Verdrahtungsbeabstandung verringert, wobei sich die Verdrahtungshöhe nicht verringert. Aufgrund der kapazitiven Kopplung zwischen On-Chip-Verdrahtungen kann es zu einem Nebensprechen zwischen digitalen Leitungen führen, die eine effektive Laufzeitverzögerung der Signale hervorrufen kann. Diese Verzögerung nimmt einen immer größeren prozentualen Anteil der Taktperiode an, und kann daher zu einem begrenzenden Faktor für die Taktgeschwindigkeit auf einem Chip werden.

Die wissenschaftliche Veröffentlichung "Optimization of error detecting codes for the detection of crosstalk originated errors" von M. Favalli und C. Metra befaßt sich mit der Optimierung von Fehlererfassungs-Codes für die Erfassung von Fehlern, die durch ein Nebensprechen hervorgerufen werden, wobei gewichtungsbasierte Codes für die Erfassung von Fehlern, die durch ein Nebensprechen hervorgerufen werden, verwendet werden.

Die wissenschaftliche Veröffentlichung von S. Hronik, "The Myth of Ground Bounce Measurements and Comparisons", Application Note AN-147, Integrated Device Technolgy, Inc., 1996, S. 89 - 98, bezieht sich auf die Problematik des gleichzeitigen Umschaltrauschens bzw. synchronen Umschaltrauschens in Folge von Massepotentialsprüngen, wobei ein Massepotentialsprung als Spannungsoszillation zwischen dem Masseanschlussstift an einem Komponentengehäuse und dem Massereferenzpegel an dem Komponentenchip bezeichnet wird. Im wesentlichen werden Massepotentialsprünge durch einen Stromstoß verursacht, der durch die Anschlussinduktivität des Gehäuses läuft. Dieser Effekt tritt dann am stärksten auf, wenn alle Ausgänge des Chips gleichzeitig umschalten.

Ausgehend von diesem Stand der Technik besteht die Aufgabe der vorliegenden Erfindung darin, ein Konzept zur sicheren und zuverlässigen Datenkommunikation zwischen elektronischen Bausteinen zu schaffen.

Diese Aufgabe wird durch Codierer gemäß Anspruch 1, durch ein Verfahren zum Codieren eines Datenworts gemäß Anspruch 11 und durch einen Decodierer gemäß Anspruch 12 gelöst.

Der vorliegenden Erfindung liegt die Erkenntnis zugrunde, daß die Datenübertragung zwischen zwei miteinander kommunizierenden elektronischen Halbleiterbausteinen über einen Datenbus bei hohen Taktfrequenzen sicher durchgeführt werden kann, indem eine gezielte und explizite Änderung, d. h. Codierung, der Datensignale auf der Senderseite, also bei dem sendenden elektronischen Halbleiterbaustein, durchgeführt wird, so daß die störenden Effekte bei der Datenübertragung, wie z. B. interne Versorgungsspannungseinbrüche aufgrund des gleichzeitigen Schaltens einer großen Anzahl identischer Signalwerte, vermieden werden oder nur noch in deutlich abgeschwächter Form auftreten können. Dabei werden außerdem von dem dem Senderbaustein zugeordneten Codierer sogenannte Hilfsinformationen erzeugt, die auf die Änderung(en) des codierten Datensignals gegenüber dem ursprünglichen Datensignal hinweisen. Das codierte Datensignal und die Hilfsinformationen werden nun zu dem empfangenden elektronischen Halbleiterbaustein übertragen, der unter Verwendung der mitübermittelten Hilfsinformationen die codierten Datensignale in die ursprünglichen Datensignale rückcodiert. Damit wird eine sichere Datenübertragung auch bei hohen Taktfrequenzen und bei großer Bit-Breite des Datenwortes über die jeweiligen Datenbusse sichergestellt.

Das allgemeine Prinzip der vorliegenden Erfindung besteht also darin, daß bei einem elektronischen System bestehend aus Sender- und Empfängerbaustein, die über einen Datenbus mit einer bestimmten Bitbreite miteinander kommunizieren, zur Verringerung des synchronen Schaltrauschens SSN im Senderbaustein ein Codierer und in dem Empfängerbaustein ein entsprechender Decodierer vorgesehen sind. Die Aufgabe des Codierers ist es nun, beim Auftreten eines Datenworts, welches zu einem verstärken synchronen Schaltrauschen SSN führt, eine Umcodierung des zu sendenden Datenworts vorzunehmen, so daß eine Reduzierung des synchronen Schaltrauschens SSN erfolgt. Die Codierung kann beispielsweise über eine zusätzliche Datenleitung dem Empfängerbaustein mitgeteilt werden, d. h. es werden Hilfsinformationen bzgl. des codierten Datenworts übermittelt, die auf die Codierung des Datenworts hinweisen. Mit Hilfe dieser Hilfsinformationen kann durch den Decodierer, der dem Empfängerbaustein zugeordnet ist, wieder eine Rückcodierung auf das ursprüngliche Datenwort vorgenommen werden.

Ein mögliche Realisierung der vorliegenden Erfindung besteht nun darin, daß dem sendenden elektronischen Baustein ein Codierer zugeordnet ist, der ein Datenwort, das auf einem Datenbus parallel übertragen werden soll, codieren kann. Der Codierer untersucht dabei das Datenwort, um festzustellen, ob das gerade vorliegende, zu übertragende Datenwort eine zu große Anzahl von Bits mit einem gleichen Zustand aufweist, d. h. das zu übertragende Datenwort weist sehr viele logische "0"- oder "1"-Zustände auf, so daß ein Problem dahingehend auftreten kann, daß für das Datenwort bei der Übertragung eine zu große Anzahl identischer Signalwerte gleichzeitig umgeschaltet werden muß. Um dies zu vermeiden, ändert der Codierer ein Bit oder mehrere Bits des Datenworts, um ein codiertes Datenwort zu erzeugen, so daß die Anzahl von Bits mit einem gleichen Zustand unter eine vorbestimmte Schwelle sinkt, die eine sichere Übertragung des Datenworts über den Datenbus gewährleistet. Der Codierer erzeugt ferner sogenannte Hilfsinformationen, die die Informationen bezüglich der Änderung(en) des codierten Datenworts gegenüber dem ursprünglichen Datenwort beinhalten, wobei diese Hilfsinformationen mit dem codierten Datenwort übertragen werden, so daß ein Decodierer in dem empfangenden elektronischen Halbleiterbaustein nach Empfang des codierten Datenworts unter Berücksichtigung der Hilfsinformationen das ursprüngliche Datenwort zurückgewinnen kann.

Eine einfache, praktische Anordnung zur Verringerung des synchronen Schaltrauschens SSN für die erfindungsgemäße Codierer- bzw. Decodiereranordnung besteht nun darin, daß eine Komparatoreinrichtung erkennt, ob ein Datenwort mit einer großen Anzahl von gleichen Signalwerten übertragen werden soll, z. B. ob eine großer Teil aller Signalwerte logisch "1" oder "0" ist. In diesem Fall werden durch die Komparatoreinrichtung beispielsweise programmierbare Invertierer aktiviert, die den auf ihrer Signalleitung anliegenden Signalwert vor der Zuführung zu den Ausgangstreibern des Senderbausteins invertieren. Für den Fall, daß die Verteilung der Signalwerte in dem zu übertragenden Datenwort eine problemlose Übertragung des Datenworts ermöglicht, lassen die Treibereinrichtungen ansonsten ihre Eingangssignale, d. h. das Datenwort, unverändert passieren.

In dem Empfängerbaustein kann nun der Decodierer die empfangenen codierten Signalwerte unter Berücksichtigung der mit-übertragenen Hilfsinformationen in das ursprüngliche Datenwort zurückcodieren. Dabei ist beispielsweise die Komparatoreinrichtung in dem Codierer direkt mit entsprechenden Invertierern in dem Decodierer verbunden, um wieder eine Rückcodierung des Datenworts durch eine Aktivierung der jeweiligen Invertierer in dem Decodierer vorzunehmen, um so das ursprüngliche Datenwort wieder zu erhalten.

Ein Vergleichsbeispiel für einen Codierer zum Codieren eines Datenworts, das parallel über einen Datenbus übertragen werden soll, besteht darin, daß der Codierer das zu übertragende Datenwort mit einem vorhergehenden Datenwort, d. h. mit dem unmittelbar davor übertragenen Datenwort, vergleicht, um festzustellen, ob die Anzahl gleichzeitiger Schaltvorgänge von identischen Signalwerten zwischen dem noch zu übertragenden Datenwort und dem vorhergehenden Datenwort eine vorbestimmte Schwelle für eine sichere Datenübertragung überschreitet. Falls diese vorbestimmte Schwelle durch das zu übertragene Datenwort überschritten wird, ändert der Codierer das zu übertragende Datenwort ab, um ein codiertes Datenwort zu erzeugen, das ohne Probleme zu dem empfangenden elektronischen Halbleiterbaustein übertragen werden kann. Falls die vorbestimmte Schwelle vom dem zu übertragenden Datenwort nicht überschritten wird, wird das Datenwort unverändert übertragen.

Auch hier erzeugt der Codierer Hilfsinformationen, die auf die Änderungen in dem codierten Datenwort hinweisen, so daß das codierte Datenwort unter Verwendung der Hilfsinformationen in dem Decodierer, der dem empfangenden elektronischen Halbleiterbaustein zugeordnet ist, wieder in das ursprüngliche Datenwort decodiert werden kann. Auch in diesem Fall können beispielsweise Invertierer zum Ändern der Signalwerte des Datenworts verwendet werden.

Es können natürlich auch sehr komplizierte und komplexe Anordnungen zum Einsatz kommen, die das zuletzt übertragene Datenwort mit dem nächsten zu übertragenden Datenwort vergleichen und aufgrund dieser Informationen eine komplizierte bzw. komplexe Codierung des zu übertragenden Datenworts vornehmen, um das synchrone Schaltrauschen SSN maximal zu reduzieren. Hierbei kann die Datenleitung, mit der die Zusatzinformationen übertragen werden, auch ein komplizierter Datenbus sein, um dem Decodierer komplexe Decodierinformationen zur Verfügung stellen zu können. Die Datenleitung zur Übertragung der Codierinformationen kann aber auch Teil des Datenbusses selbst sein.

Darüber hinaus ist es auch möglich, die Hilfsinformationen direkt in das codierte zu übertragende Datenwort einzucodieren, wobei der Decodierer auf der Empfangsseite dann selbst erkennt, wann und in welcher Form eine Decodierung zu erfolgen hat.

Das vorliegende erfindungsgemäße Konzept zur sicheren Datenkommunikation zwischen elektronischen Bausteinen ermöglicht somit auch bei immer weiter steigenden Taktfrequenzen und immer größeren Busbreiten bei zukünftigen elektronischen Systemen eine zuverlässige Datenkommunikation zwischen den einzelnen elektronischen Bausteinen, die über einen Datenbus miteinander kommunizieren, wobei sich das erfindungsgemäße Konzept insbesondere bei Speicherbausteinen zum schnellen und zuverlässigen Ein- und Auslesen von Speicherinformationen anbietet.

Mit der vorliegenden Erfindung kann somit einer in wenigen Jahren zu erwartenden Begrenzung der Systemfrequenz aufgrund des synchronen Schaltrauschens SSN bei der Datenübertragung über Datenbusse vorgebeugt werden, indem erfindungsgemäß die zu übertragenden Datensignale gezielt und explizit geändert werden, so daß das synchrone Schaltrauschen SSN und auch andere störende Effekte auf das zu übertragende Datensignal weitestgehend unterdrückt werden können.

Bevorzugte Ausführungsbeispiele der vorliegenden Erfindung werden nachfolgend bezugnehmend auf die beiliegenden Zeichnungen näher erläutert. Es zeigen:
- Fig. 1a: unterschiedliche Signaldaten S1 - S3 aufeinaderfolgender Datenwörter über einen Zeitraum von drei Taktzyklen;
- Fig. 1b: ein sich aus einer überlagerten Darstellung vieler Signaldaten ergebendes sog. "Datenauge";
- Fig. 2: eine allgemeine, prinzipielle Codierer/Decodiereranordnung gemäß der vorliegenden Erfindung; und
- Fig. 3: eine Codierer/Decodiereranordnung gemäß einem ersten Ausführungsbeispiel der vorliegenden Erfindung.

Anhand von Fig. 2 wird nun ein allgemeines, prinzipielles Ausführungsbeispiel des erfindungsgemäßen Codierer/Decodiererkonzepts zur sicheren Datenkommunikation über einen Datenbus zwischen zwei elektronischen Halbleiterbausteinen erläutert, um das sogenannte synchrone Schaltrauschen SSN in einem zu übertragenden Datensignal zu verringern.

Wie bereits eingangs erörtert, hat vor allem das synchrone Schaltrauschen zur Folge, daß sich ein resultierendes "Datenauge" mit verringerter Breite ergibt, wobei das Datenauge ein Indikator dafür ist, in welchem Zeitraum, auf den Taktzyklus bezogen, alle Signalwerte, die über den Datenbus übertragen werden, stabil sind, d. h. in welchem Zeitraum ein die Daten empfangender elektronischer Baustein die Eingangssignale an seinen Eingängen bewerten kann, da ansonsten unter Umständen ein falscher Signalwert ausgelesen bzw. interpretiert werden würde. Die Form und Breite des resultierenden Datenauges (vgl. Fig. 1b) gibt somit die Übertragungsqualität an, d. h. wie über den Datenbus übertragene Datensignale am Empfängerbaustein aufgelöst werden können.

Bezugnehmend auf Fig. 2 ist ein erster elektronischer Halbleiterbaustein 10, der im folgenden als Senderbaustein 10 bezeichnet wird, und ein zweiter elektronischer Halbleiterbaustein 12, der im folgenden als Empfängerbaustein 12 bezeichnet wird, dargestellt. Die beiden elektronischen Halbleiterbausteine 10, 12 kommunizieren über einen parallelen Datenbus 14 mit einer vorgegebenen Bitbreite miteinander. Der Senderbaustein 10 weist einen Codierer 16 auf, dem die von dem Senderbaustein 10 auszugebenden Signaldaten S₁ - S_{N} zugeführt werden.

Der Ausgang des Codierers 16 ist mit einer Treibereinrichtung 18 des Senderbausteins 10 verbunden, die den Ausgang des Senderbaustein 10 bildet. Die Treibereinrichtung 18 besteht aus einer Mehrzahl von Signaltreibern, wobei ein Signaltreiber pro Signalleitung des Datenbusses 16 vorgesehen ist. Die Treibereinrichtung 18 ist vorgesehen, um die von dem Codierer 16 ausgegebenen Signaldaten auf dem Datenbus 14 zu dem Empfängerbaustein 12 zu treiben.

Die Signaldaten S₁ - S_{N}, wobei der Index N die Bitbreite des Datenworts angibt, das von dem Senderbaustein 10 zu dem Empfängerbaustein 12 über den Datenbus 14 übertragen werden soll, werden dem Codierer 16 von dem Senderbaustein 10 zur Verfügung gestellt. Das auf dem Datenbus 14 parallel zu übertragende Datenwort weist dabei eine Vielzahl von Bits (N Bits) auf, wobei für jedes Bit des Datenworts eine einzelne Busleitung des Datenbusses 14 vorgesehen ist. Jedes Bit des Datenworts kann einen von zwei logischen Zuständen annehmen, wobei diese logischen Zustände komplementär zueinander, d. h. logisch "0" bzw. logisch "1", sind.

Der Senderbaustein 10 weist ferner ausgangsseitig eine weitere Treibereinrichtung 20 auf, die vorgesehen ist, um Hilfs- oder Codierinformationen des Codierers 16 auf einer zusätzlichen Datenleitung 22 zu dem Empfängerbaustein 12 zu übertragen. Der Empfängerbaustein 12 weist eingangsseitig eine Empfangstreibereinrichtung 24 auf, die mit dem Datenbus 14 verbunden ist, um die auf dem Datenbus 14 übertragenen Signaldaten zu empfangen, wobei ein Signaltreiber für jede Signalleitung des Datenbusse vorgesehen ist. Der Empfängerbaustein 12 umfaßt ferner eine weitere Empfangstreibereinrichtung 26, die vorgesehen ist, die auf der Datenleitung 22 übertragenen Codierinformationen zu empfangen. Der Empfängerbaustein 12 umfaßt einen Decodierer 28, dessen Eingang mit den Empfangstreibereinrichtungen 24, 26 verbunden ist. Der Decodierer 28 stellt ausgangsseitig die decodierten Signaldaten S₁ - S_{N} bereit.

Im folgenden wird nun ein erstes Ausführungsbeispiel des erfindungsgemäßen Konzepts zur sicheren Datenkommunikation zwischen zwei elektronischen Bausteinen mittels eines Codierers in dem Senderbaustein und eines Decodierers in dem Empfängerbaustein dargestellt.

Der Codierer 16 des Senderbausteins 10 untersucht das zu übertragende Datenwort, d. h. die Signaldaten S₁ - S_{N}, um festzustellen, ob bei einer Übertragung dieses Datenworts ein verstärktes synchrones Schaltrauschen SSN auftreten könnte. Dies wird durchgeführt, indem erfaßt wird, wie viele Bits des zu übertragenden Datenworts einen ersten logischen Zustand und einen zweiten logischen Zustand aufweisen. Falls festgestellt wird, daß relativ viele gleiche logische Zustände, d. h. sehr viele "0"-Werte oder sehr viele "1"-Werte, in dem zu übertragenden Datenwort vorhanden sind, kann dies bei der Übertragung dieses Datenworts zu einer Vielzahl von gleichzeitigen Schaltvorgängen identischer Signalwerte führen, was, wie bereits erörtert, aufgrund interner Versorgungsspannungseinbrüche der Treibereinrichtungen 18, 20 zu dem synchronen Schaltrauschen SSN und damit zu dem bereits ausführlich anhand von Fig. 1b erläuterten resultierenden "Datenauge" mit verringerter effektiver Breite führen kann.

Aus diesem Grund wird in dem Codierer 16 eine vorbestimmte Schwelle vorgegeben, die angibt, um welchen Wert eine Anzahl von Bits mit einem ersten Zustand des Datenworts von einer zweiten Anzahl von Bits mit einem zweiten Zustand des Datenworts abweichen darf, d. h. um welchen Wert die Anzahl der logischen "1"-Werte von der Anzahl der logischen "0"-Werte der Signaldaten des jeweiligen Datenworts differieren darf, um trotzdem noch eine sichere und zuverlässige Datenübertragung über einen Datenbus zwischen verschiedenen elektronischen Bausteinen zu gewährleisten.

Die vorbestimmte Schwelle ist dabei ein vorgegebenes Verhältnis zwischen der Anzahl von Bits mit einem ersten logischen Zustand des Datenworts und der zweiten Anzahl von Bits mit einem zweiten logischen Zustand des Datenworts. Das vorgegebene Verhältnis wird in der Praxis nun gewählt, um abhängig von der Bitbreite des Datenworts und der Bustaktfrequenz ein resultierendes Datenauge zu erhalten, das ein sicheres und zuverlässiges Bewerten der übertragenen Signaldaten gewährleistet. Für das vorgegebene Verhältnis zwischen den zu übertragenen Datenwerten, d. h. zwischen den logischen "0"- und "1"-Werten des Datenworts, können daher abhängig von den jeweiligen elektronischen Bausteinen beliebige Werte (2:1, 3:1, ... und auch Zwischenwerte davon) gewählt werden.

Wird die vorgegebene Schwelle durch die Signaldaten S₁ - S_{N} des zu übertragenden Datenworts überschritten, d. h. ist zu erwarten, daß bei diesem Datenwort eine zu große Anzahl identischer Signalwerte gleichzeitig umgeschaltet werden muß, führt der Codierer 16 eine Änderung des Zustands zumindest eines Bits des Datenworts durch, um ein codiertes Datenwort zu erhalten, das die vorbestimmte Schwelle unterschreitet, so daß bei der Übertragung im allgemeinen ein geringes synchrones Schaltrauschen SSN erreicht wird. Sollte das zu übertragende Datenwort die vorgegebene Schwelle nicht überschreiten, wird das Datenwort ohne Veränderung über den Datenbus 14 übertragen.

Um das codierte Datenwort in dem dem Empfängerbaustein 12 zugeordneten Decodierer 28 wieder Decodieren zu können, erzeugt der Codierer 16 ferner sogenannte Hilfsinformationen, die auf die in dem Datenwort vorgenommenen Änderungen hinweisen. Diese Hilfsinformationen werden beispielsweise über die zusätzliche Datenleitung 22 zu dem dem Empfängerbaustein 12 zugeordneten Decodierer 28 übertragen.

Dem Decodierer 28, der dem Empfängerbaustein 12 zugeordnet ist, werden nun das codierte Datenwort und die dem codierten Datenwort zugeordneten Hilfsinformationen bereitgestellt. Unter Verwendung der Hilfsinformationen decodiert nun der Decodierer 28 das codierte Datenwort in das ursprüngliche Datenwort zurück. Dieses wird am Ausgang des Decodierers 28 in dem Empfängerbaustein 12 bereitgestellt.

Das Prinzip diese Ausführungsbeispiels der vorliegenden Erfindung läßt sich also folgendermaßen zusammenfassen. Ein Senderbaustein 10 und ein Empfängerbaustein 12 kommunizieren über einen Datenbus 14 mit vorgegebener Bitbreite, die der Bitbreite eines zu übertragenden Datenworts entspricht. Zur Verringerung des oben erörterten synchronen Schaltrauschens SSN und/oder auch anderer störender Einflüsse auf das zu übertragende Datenwort wird das Datenwort codiert, wobei in dem Senderbaustein 10 ein Codierer 16 und in dem Empfängerbaustein 12 ein entsprechender Decodierer 28 vorgesehen ist. Der Codierer 16 in dem Senderbaustein 10 führt beim Auftreten eines zu übertragenden Datenworts, welches zu einem verstärkten synchronen Schaltrauschen SSN führt, eine Umcodierung des zu übertragenden Datenworts durch, so daß bei der Übertragung des Datenworts eine Verringerung des synchronen Schaltrauschens erfolgt. Die Codierungsinformationen können beispielsweise über eine zusätzliche Datenleitung 22 dem Empfängerbaustein 12 und damit dem Decodierer 28 mitgeteilt werden. Hierdurch kann durch den Decodierer 28 wieder eine Rückcodierung des codierten Datenworts in das ursprüngliche Datenwort vorgenommen werden.

Anhand von Fig. 3 wird nun eine einfache praktische Realisierung des obigen Ausführungsbeispiels für das erfindungsgemäße Codierer/Decodiererkonzept zur sicheren Datenkommunikation zwischen zwei elektronischen Halbleiterbausteinen 10, 12 erörtert.

Wie in Fig. 3 gezeigt ist, sind interne Datenleitungen 13 des Senderbausteins 10 mit dem Codierer 16 verbunden, wobei das zu übertragende Datenwort mit den Signaldaten S₁ - S₄ dem Eingang des Codierers 16 bereitgestellt wird. Zur Vereinfachung der Beschreibung wird in Fig. 3 auf ein 4 Bit breites Datenwort bezug genommen.

Der Codierer 16 umfaßt bei diesem Ausführungsbeispiel eine Komparatoreinrichtung 30, die eingangsseitig mit den einzelnen internen Datenleitungen 13 des Senderbausteins 10 verbunden ist. In den internen Datenleitungen 13 sind ferner Invertierereinrichtungen 32 geschaltet, wobei deren Steueranschlüsse mit dem Ausgang der Komparatoreinrichtung 30 verbunden sind. Der Ausgang der Komparatoreinrichtung 30 ist ferner über einen Signaltreiber 20 mit der Datenleitung 22 verbunden.

Bei dem in Fig. 3 dargestellten Beispiel sind vier interne Signalleitungen 13 vorgesehen, wobei in zwei Signalleitungen jeweils ein Invertierer 32 geschaltet ist. Die einzelnen internen Datenleitungen 13 des Senderbausteins 10 sind ausgangsseitig mit Signaltreibern 18 verbunden, um das zu übertragende Datenwort auf dem Datenbus 14 zu dem Empfängerbaustein 12 zu übertragen. Der Ausgang der Komparatoreinrichtung 30 ist ferner mit einer weiteren internen Datenleitung 13a verbunden, die mit der Treibereinrichtung 20 des Senderbausteins 10 verbunden ist, um das Ausgangssignal, d. h. die Hilfsinformationen, der Komparatoreinrichtung 30 über die Datenleitung 22 zu dem Empfängerbaustein 12 zu übertragen.

Der Datenbus 14 ist an der Eingangsseite des Empfängerbausteins 12 mit Empfangstreibern 24 verbunden, wobei die weitere Datenleitung 22 an dem Empfängerbaustein 12 eingangsseitig mit einem weiteren Empfangstreiber 26 verbunden ist. Die Empfangstreiber 24 des Empfängerbausteins 12 sind mit den internen Signalleitungen 15 des Empfängerbausteins 12 verbunden. Der weitere Empfangstreiber 26 des Empfängerbausteins 12 ist mit einer weiteren internen Datenleitung 15a des Empfängerbausteins 12 verbunden. Der Decodierer 28 des Empfängerbausteins 12 weist Invertierer 34 auf, die in den entsprechenden internen Datenleitungen 13 geschaltet sind. Die Steuereingänge der Invertierer 34 sind mit der weiteren internen Datenleitung 15b verbunden.

Im folgenden wird nun die Funktionsweise der in Fig. 3 dargestellten erfindungsgemäßen Codierer/Decodiereranordnung zur sicheren Datenkommunikation zwischen zwei elektronischen Halbleiterbausteinen erläutert.

Der Codierer 16 des Senderbausteins 10 umfaßt in dem in Fig. 3 dargestellten Fall eine Komparatoreinrichtung, die die Signalzustände der Signaldaten S₁ - S₄ des zu übertragenden Datenworts erfaßt bzw. miteinander vergleicht. Diese Komparatoreinrichtung 30 erkennt, ob eine große Anzahl an gleichen Signaldaten, d. h. mit gleichen logischen Zuständen, übertragen werden soll. Falls die Komparatoreinrichtung 30 feststellt, daß das zu übertragende Datenwort eine große Anzahl von Bits mit einem gleichen Zustand aufweist, d. h. daß eine Anzahl von Bits mit einem ersten Zustand des Datenworts von einer zweiten Anzahl von Bits mit einem zweiten Zustand des Datenworts mehr als eine vorbestimmte Schwelle abweicht, was zu einem verstärkten synchronen Schaltrauschen SSN bei der Übertragung des Datenworts führen könnte, aktiviert die Komparatoreinrichtung zumindest einen Invertierer, der in eine interne Datenleitung 13 geschaltet ist, damit die vorgegebene Schwelle unterschritten wird. Dadurch wird zumindest ein Signaldatenwert des Datenworts verändert, um das störende synchrone Schaltrauschen SSN zu verringern.

In diesem Fall werden durch die Komparatoreinrichtung 30 programmierbare Invertierereinrichtungen 32 aktiviert, die ansonsten die Signaldaten unverändert passieren lassen, falls die vorgegebene Schwelle nicht überschritten wird.

Die Anzahl der Invertierer ist dabei abhängig von der Bitbreite des Datenworts und damit der Breite des Datenbusses so gewählt, daß eine ausreichende Anzahl von Signaldaten S₁ - S₄ so geändert werden kann, um das synchrone Schaltrauschen SSN effektiv zu reduzieren bzw. zu vermeiden, d.h. durch die Änderung der Signaldaten wird das gleichzeitige Umschalten identischer Signalwerte verringert, um interne Versorgungsspannungseinbrüche zu verringern. Es ist beispielsweise möglich, so viele Invertierer vorzusehen, daß nach einer Codierung immer ein Verhältnis zwischen den logischen Signalzuständen ("0", "1") des Datenworts von ungefähr 1:1 möglich ist, wobei dazu maximal für jede zweite Signalleitung einen Invertierer erforderlich ist.

Dieses veränderte bzw. codierte Datenwort S'₁ - S'₄ wird nun über den Datenbus 14 zu dem Empfängerbaustein 12 übertragen. Ferner erzeugt die Komparatoreinrichtung 30 Hilfsinformationen, die angeben, welche Signaldaten geändert wurden. Diese Hilfsinformationen werden über die weitere Datenleitung 22 zu dem Empfängerbaustein 12 und damit zu dem Decodierer 28 übertragen.

Entsprechend den von der Komparatoreinrichtung 30 erzeugten Hilfsinformationen, die an den Decodierer 28 übertragen werden, decodiert der Decodierer 28 das empfangene, codierte Datenwort mit den veränderten Signaldaten zurück, indem der Decodierer die entsprechenden Signaldaten mit Invertierereinrichtungen 34 wieder zurück verändert, d. h. decodiert. An dem Ausgang des Decodierers 28 des Empfängerbausteins 12 wird daher wieder das ursprüngliche, decodierte Datenwort bereitgestellt.

Der Decodierer 28 verwendet nun seinerseits diese übertragenen Hilfsinformationen, um wiederum entsprechende Invertierer, die in dessen internen Datenbus 15b geschaltet sind, zu aktivieren, so daß die für die Übertragung veränderten (invertierten) Signaldaten des Datenworts wieder invertiert werden, um an dem Ausgang des Decodierers 28 wieder das ursprüngliche Datenwort bereitzustellen. Ferner sollte beachtet werden, daß die in den internen Datenbus 15b des Decodierers 28 geschalteten Invertierereinrichtungen 34 sich an entsprechenden Positionen bezüglich der in den internen Datenbus 13 des Codierers 16 geschalteten Invertierereinrichtungen 32 befinden.

In dem in Fig. 3 gezeigten Fall kann daher das zu der Ansteuerung der Invertierer in dem Codierer erzeugte Steuersignal der Komparatoreinrichtung auch als die erforderlichen Hilfsinformationen verwendet werden, da sich die Invertierer in dem Decodierer bezüglich der Invertierer in dem Codierer in "entsprechenden" Signalleitungen befinden.

Bei der in Fig. 3 dargestellten Anordnung weist der Datenbus 14 beispielhaft vier Signalleitungen auf, um ein Datenwort mit einer Breite von 4 Bit zu übertragen. Es ist jedoch offensichtlich, daß das erfindungsgemäße Codier/Decodiererkonzept auch auf Datenbusse mit beliebiger Breite anwendbar ist. In Abhängigkeit der Bitbreite des Datenbusses 14, und damit der Bitbreite der internen Datenbusse 13, 15b, muß die Anzahl der Invertierereinrichtungen 32, 34 in dem Codierer 16 bzw. dem Decodierer 28 gewählt werden, um eine genügend große Anzahl von Signaldatenwerten des Datenworts verändern zu können, um ein möglicherweise auftretendes synchrones Schaltrauschen SSN bei der Übertragung des Datenworts vermindern bzw. vermeiden zu können.

Wieder bezugnehmend auf Fig. 2 wird nun ein Vergleichsbeispiel zur sicheren Datenkommunikation zwischen einem ersten und zweiten elektronischen Baustein erörtert.

Der Codierer 16 des Senderbausteins 10 ist wiederum vorgesehen, um ein Datenwort mit einer Vielzahl von Bits zu codieren. Das Datenwort ist auf einem Datenbus parallel übertragbar, wobei für jedes Bit des Datenworts eine Busleitung vorgesehen ist. Jedes Bit des Datenworts kann einen von zwei komplementären Zuständen, d. h. logisch "0" bzw. logisch "1", annehmen. Der Codierer 16 gemäß diesem Vergleichsbeispiel vergleicht nun das zu übertragende Datenwort mit dem direkt vorher übertragenen Datenwort. Dabei wird festgestellt, ob die Anzahl der Übergänge zwischen den zwei komplementären Zuständen jedes Bits des zu übertragenden Datenworts und des direkt vorher übertragenen Datenworts eine vorbestimmte Schwelle überschreitet, die zu einem erhöhten synchronen Schaltrauschen SSN bei der Übertragung des Datenworts führen kann. Falls der Codierer 16 feststellt, daß diese vorbestimmte Schwelle durch das zu übertragende Datenwort überschritten wird, ändert der Codierer 16 den Zustand eines Bits des Datenworts, um ein codiertes, zu übertragendes Datenwort zu erzeugen, das das Auftreten des synchronen Schaltrauschens SSN verringert bzw. vermeidet. Gleichzeitig erzeugt der Codierer 16 Hilfsinformationen bezüglich der Codierung, die auf die Änderungen in dem codierten Datenwort hinweisen.

Diese sogenannten Hilfsinformationen können, wie bei dem vorher dargestellten Vergleichsbeispiel, beispielsweise über eine getrennte Datenleitung 22 an den Decodierer 28 des Empfangsbausteins 12 übermittelt werden, wobei es auch möglich ist, die Hilfsinformationen direkt in das codierte Datenwort einzucodieren.

Mittels der übertragenen Hilfsinformationen, die dem Codierer 28 des Empfangsbausteins getrennt oder auch in das codierte Datenwort eincodiert bereitgestellt werden, kann der Decodierer 28 das ursprüngliche Datenwort wiederherstellen. Auch bei diesem Vergleichsbeispiel können Invertierer zum Ändern der Signalwerte des Datenworts verwendet werden.

Bei diesem Vergleichsbeispiel können aber auch komplizierte Codierungsverfahren zum Einsatz kommen, so daß, wie oben erörtert, das zuletzt übertragene Datenwort mit dem nächsten zu übertragenden Datenwort verglichen wird, und aufgrund dieser Informationen eine komplexe bzw. komplizierte Codierung vorgenommen wird, um das synchrone Schaltrauschen maximal zu reduzieren. Hierbei kann die Datenleitung 22 zur Übertragung der Hilfsinformationen auch ein komplizierterer Bus sein, um dem Decodierer 28 des Empfängerbausteins 12 komplexe Decodierinformationen (Hilfsinformationen) zur Verfügung zu stellen.

Es ist zu beachten, daß die Datenleitung 22 zur Übertragung der Hilfsinformationen auch ein Teil des Datenbusses 14 sein kann, d. h. durch das übertragene codierte Datenwort erkennt der Decodierer 28, wann und in welcher Form eine Decodierung erfolgen muß.

Die im vorhergehenden beschriebenen Konzepte zur sicheren Datenkommunikation zwischen elektronischen Halbleiterbausteinen bieten sich insbesondere dann an, wenn der Empfängerbaustein 12 ein Speicherbaustein, z. B. ein DRAM-Baustein, ist. Damit kann in Zukunft zwischen Speicherbausteinen und weiteren elektronischen Bausteinen auch bei elektronischen Systemen, die in Zukunft immer komplexerer sein werden, eine sichere und zuverlässige Datenkommunikation auch bei hohen Taktfrequenzen und hohen Bitbreiten des Datenbusses sichergestellt werden.

### Bezugszeichenliste

- 10: Senderbaustein
- 12: Empfängerbaustein
- 13: interne Datenleitungen
- 13a: interne Datenleitung
- 14: Datenbus
- 15: interne Datenleitungen
- 15a: interne Datenleitung
- 16: Codierer
- 18: Sendetreibereinrichtung
- 20: Sendetreibereinrichtung
- 22: Datenleitung
- 24: Empfangstreibereinrichtung
- 26: Empfangstreibereinrichtung
- 28: Decodierer
- 30: Komparatoreinrichtung
- 32: Invertierereinrichtung
- 34: Invertierereinrichtung

## Patentansprüche

1. Codierer (16) zum Codieren eines Datenworts mit einer Vielzahl von Bits, um bei einer Übertragung des Datenworts bezüglich eines Synchronen Schaltrauschens SSN eine zuverlässige Bewertung des Zustands jedes Bits des Datenworts zu gewährleisten, wobei jedes Bit des Datenworts auf einer Busleitung eines Datenbusses (14) mit einer Mehrzahl von Busleitungen parallel übertragbar ist, und wobei jedes Bit einen von zwei Zuständen annehmen kann, mit folgenden Merkmalen:
einer Komparatoreinrichtung (30) zum Untersuchen des Datenworts, um festzustellen, ob eine erste Anzahl von Bits mit einem ersten logischen Zustand des Datenworts von einer zweiten Anzahl von Bits mit einem zweiten logischen Zustand des Datenworts um mehr als eine vorbestimmte Schwelle abweicht, wobei die vorbestimmte Schwelle gewählt ist, um bei einer Unterschreitung der vorbestimmten Schwelle eine sichere Übertragung des Datenworts bezüglich einer zuverlässigen Bewertung des Zustands jedes Bits des Datenworts zu gewährleisten, wobei die Komparatoreinrichtung (30) einen Komparatorausgang aufweist;
einer Einrichtung zum Ändern des Zustands einer Mehrzahl von Bits des Datenworts, um ein codiertes Datenwort zu erzeugen, wenn das Datenwort die vorbestimmte Schwelle überschreitet, wobei die Einrichtung zum Ändern eine von der Anzahl von Busleitungen abhängige Anzahl von programmierbaren Invertierereinrichtungen (32) aufweist, um eine genügend große Anzahl von Bits des Datenworts zu verändern, um das synchrone Schaltrauschen SSN bei der Übertragung des codierten Datenworts zu vermindern oder zu vermeiden, wobei die programmierbaren Invertierereinrichtungen (32) Steueranschlüsse aufweisen, die mit dem Komparatorausgang verbunden sind;
einem Signaltreiber (20), der mit dem Komparatorausgang verbunden ist, zum Übertragen des Ausgangssignals der Komparatoreinrichtung (30) als Hilfsinformation auf einer zusätzlichen Datenleitung (22).

2. Codierer gemäß Anspruch 1, bei dem die vorbestimmte Schwelle ein vorgegebenes Verhältnis zwischen der Anzahl von Bits mit einem ersten logischen Zustand des Datenworts und der zweiten Anzahl von Bits mit einem zweiten logischen Zustand des Datenworts ist.

3. Codierer gemäß Anspruch 1 oder 2, bei dem die zwei Zustände, die jedes Bit eines Datenworts annehmen kann, komplementäre logische Zustände sind.

4. Codierer gemäß einem der Ansprüche 1 bis 3, bei dem der Codierer (16) mit dem Datenbus (14) verbindbar ist.

5. Codierer gemäß einem der Ansprüche 1 bis 4, bei dem für jede Busleitung des Datenbusses (14) eine Treibereinrichtung (18) vorgesehen ist.

6. Codierer gemäß einem der Ansprüche 1 bis 5, bei dem die Einrichtung zum Untersuchen des Datenworts eine Komparatoreinrichtung (30) ist, die die logischen Zustände des Datenwortes vergleicht.

7. Codierer gemäß einem der Ansprüche 1 bis 6, wobei der Codierer (16) eine Invertierereinrichtung (32) aufweist, um den Zustand eines Bits des Datenworts zu ändern.

8. Codierer gemäß einem der Ansprüche 1 bis 7, wobei der Codierer (16) mit einer Datenleitung (22) verbindbar ist, um die Hilfsinformationen zu übertragen.

9. Codierer gemäß Anspruch 8, bei dem die Datenleitung (22) Teil des Datenbusses (14) ist.

10. Codierer gemäß einem der Ansprüche 1 bis 9, wobei der Codierer (16) Teil eines elektrischen Bausteins (10) ist, der mit einem Speicherbaustein (12) kommuniziert.

11. Verfahren zum Codieren eines Datenworts mit einer Vielzahl von Bits, um bei einer Übertragung des Datenworts bezüglich eines Synchronen Schaltrauschens SSN eine zuverlässige Bewertung des Zustands jedes Bits des Datenworts zu gewährleisten, wobei das Datenwort auf einem Datenbus (14) mit einer Mehrzahl von Busleitungen parallel übertragbar ist, wobei für jedes Bit eine Busleitung vorgesehen ist, und wobei jedes Bit einen von zwei Zuständen annehmen kann, mit folgenden Schritten:
Untersuchen des Datenworts mit einer Komparatoreinrichtung, um festzustellen, ob eine erste Anzahl von Bits mit einem ersten logischen Zustand des Datenworts von einer zweiten Anzahl von Bits mit einem zweiten logischen Zustand des Datenworts um mehr als eine vorbestimmte Schwelle abweicht, wobei die vorbestimmte Schwelle gewählt ist, um bei einer Unterschreitung der vorbestimmten Schwelle eine sichere Übertragung des Datenworts bezüglich einer zuverlässigen Bewertung des Zustands jedes Bits des Datenworts zu gewährleisten, wobei die Komparatoreinrichtung einen Komparatorausgang aufweist;
Ändern des Zustands einer Mehrzahl von Bits des Datenworts mit einer Anzahl von programmierbaren Invertierereinrichtungen, um ein codiertes Datenwort zu erzeugen, wenn das Datenwort die vorbestimmte Schwelle überschreitet, wobei die Anzahl von programmierbaren Invertierereinrichtungen von der Anzahl von Busleitungen abhängt, um eine genügend große Anzahl von Bits des Datenworts zu verändern, um das synchrone Schaltrauschen SSN bei der Übertragung des codierten Datenworts zu vermindern oder zu vermeiden, wobei die programmierbaren Invertierereinrichtungen Steueranschlüsse aufweisen, die mit dem Komparatorausgang verbunden sind; und
Übertragen des Ausgangssignals der Komparatoreinrichtung mit einem Signaltreiber (20), der mit dem Komparatorausgang verbunden ist, als Hilfsinformation auf einer zusätzlichen Datenleitung.

12. Decodierer (28) zum Decodieren eines codierten Datenworts mit einer Vielzahl von Bits, wobei jedes Bit des Datenworts auf einer Busleitung eines Datenbusses (14) mit einer Mehrzahl von Busleitungen parallel übertragbar ist, und wobei jedes Bit einen von zwei Zuständen annehmen kann, mit folgenden Merkmalen:
einer Einrichtung zum Empfangen des codierten Datenworts von dem Datenbus (14), wobei für jede Busleitung des Datenbusses (14) ein Empfangstreiber (24) vorgesehen ist, und wobei ferner ein weiterer Empfangstreiber (26) für eine zusätzliche Datenleitung vorgesehen ist, wobei bestimmten Empfangstreibern (24) jeweils eine programmierbare Invertierereinrichtung (34) nachgeschaltet ist, wobei eine Anzahl der programmierbaren Invertierereinrichtungen (34) und eine Zuordnung der programmierbaren Invertierereinrichtungen (34) zu den Bitleitungen der Anzahl und Zuordnung von programmierbaren Invertieren (32) eines zugeordneten Codierers (16) entsprechen, wobei die programmierbaren Invertierereinrichtungen Steuereingänge aufweisen, die mit dem Ausgang des weiteren Empfangstreibers (26) verbunden sind, um das codierte Datenwort entsprechend dem auf der zusätzlichen Datenleitung als Hilfsinformation übertragenen Signal rückzucodieren.

## Claims

1. Encoder (16) for encoding a data word having a plurality of bits, in order to ensure reliable evaluation of the state of each bit of the data word with regard to synchronous switching noise SNN when transmitting the data word, wherein each bit of the data word is transmittable in parallel on a bus line of a data bus (14) having a plurality of bus lines, and wherein each bit may assume one of two states, comprising:
a comparator means (30) for examining the data word in order to determine whether a first number of bits with a first logical state of the data word deviates from a second number of bits with a second logical state of the data word by more than a predetermined threshold, the predetermined threshold being chosen to ensure a secure transmission of the data word with regard to reliable evaluation of the state of each bit of the data word when falling below the predetermined threshold, the comparator means (30) having a comparator output;
a means for changing the state of a plurality of bits of the data word in order to create an encoded data word if the data word exceeds the predetermined threshold, wherein the means for changing has a number of programmable inverter means (32) dependent on the number of bus lines, in order to change a sufficiently great number of bits of the data word to reduce or avoid the synchronous switching noise SNN when transmitting the encoded data word, the programmable inverter means (32) having control terminals connected to the comparator output;
a signal driver (20), connected to the comparator output, for transmitting the output signal of the comparator means (30) as auxiliary information on an additional data line (22).

2. Encoder according to claim 1, wherein the predetermined threshold is a preset ratio between the number of bits with a first logical state of the data word and the second number of bits with a second logical state of the data word.

3. Encoder according to claim 1 or 2, wherein the two states that each bit of a data word may assume are complementary logical states.

4. Encoder according to one of claims 1 to 3, wherein the encoder (16) is connectable to the data bus (14).

5. Encoder according to one of claims 1 to 4, wherein for each bus line of the data bus (14) a driver means (18) is provided.

6. Encoder according to one of claims 1 to 5, wherein the means for examining the data word is a comparator means (30) comparing the logical states of the data word.

7. Encoder according to one of claims 1 to 6, wherein the encoder (16) comprises an inverter means (32) in order to change the state of a bit of the data word.

8. Encoder according to one of claims 1 to 7, wherein the encoder (16) is connectable to a data line (22) in order to transmit the auxiliary information.

9. Encoder according to claim 8, wherein the data line (22) is part of the data bus (14).

10. Encoder according to one of claims 1 to 9, wherein the encoder (16) is part of an electric device (10) communicating with a memory device (12).

11. Method for encoding a data word having a plurality of bits, in order to ensure reliable evaluation of the state of each bit of the data word with regard to synchronous switching noise SNN when transmitting the data word, wherein the data word is transmittable in parallel on a data bus (14) having a plurality of bus lines, wherein one bus line is provided for each bit and wherein each bit may assume one of two logical states, comprising:
examining the data word with a comparator means in order to determine whether a first number of bits with a first logical state of the data word deviates from a second number of bits with a second logical state of the data word by more than a predetermined threshold, the predetermined threshold being chosen to ensure a secure transmission of the data word with regard to reliable evaluation of the state of each bit of the data word when falling below the predetermined threshold, the comparator means having a comparator output;
changing the state of a plurality of bits of the data word with a number of programmable inverter means in order to create an encoded data word if the data word exceeds the predetermined threshold, wherein the number of programmable inverter means depends on the number of bus lines, in order to change a sufficiently great number of bits of the data word to reduce or avoid the synchronous switching noise SNN when transmitting the encoded data word, the programmable inverter means having control terminals connected to the comparator output; and
transmitting the output signal of the comparator means as auxiliary information on an additional data line with a signal driver (20) connected to the comparator output.

12. Decoder (28) for decoding an encoded data word, wherein each bit of the data word is transmittable in parallel on a bus line of a data bus (14) having a plurality of bus lines, and wherein each bit may assume one of two states, comprising:
a means for receiving the encoded data word from the data bus (14), wherein a receive driver (24) is provided for each bus line of the data bus (14), and wherein also a further receive driver (26) is provided for an additional data line, with one programmable inverter means (34) each being connected downstream to certain receive drivers (24), with a number of the programmable inverter means (34) and an association of the programmable inverter means (34) with the bit lines corresponding to the number and association of programmable inverters (32) of an associated encoder (16), the programmable inverter means having control inputs connected to the output of the further receive driver (26) to encode back the encoded data word corresponding to the signal transmitted as auxiliary information on the additional data line.

## Revendications

1. Codeur (16) pour coder un mot de données avec une pluralité de bits, pour garantir, lors d'une transmission du mot de données, en ce qui concerne un bruit de commutation synchrone SSN, une évaluation fiable de l'état de chaque bit du mot de données, chaque bit du mot de données pouvant être transmis en parallèle sur une ligne de bus d'un bus de données (14) avec une pluralité de lignes de bus, et chaque bit pouvant adopter l'un de deux états, aux caractéristiques suivantes :
un dispositif comparateur (30) destiné à examiner le mot de données, pour constater si un premier nombre de bits avec un premier état logique du mot de données s'écarte d'un deuxième nombre de bits avec un deuxième état logique du mot de données de plus d'un seuil prédéterminé, le seuil prédéterminé étant choisi pour garantir, en cas de descente au-dessous du seuil prédéterminé, une transmission sûre du mot de données en ce qui concerne une évaluation fiable de l'état de chaque bit du mot de données, le dispositif comparateur (30) présentant une sortie de comparateur ;
un dispositif destiné à modifier l'état d'une pluralité de bits du mot de données, pour générer un mot de données codé lorsque le mot descend au-dessous du seuil prédéterminé, le dispositif destiné à modifier présentant un nombre de dispositifs d'inversion programmables (32) en fonction du nombre de lignes de bus, pour modifier un nombre suffisamment grand de bits du mot de données pour réduire ou éviter le bruit de commutation synchrone SSN lors de la transmission du mot de données codé, les dispositifs d'inversion programmables (32) présentant des connexions de commande qui sont reliées à la sortie de comparateur ;
un pilote de signal (20) qui est relié à la sortie de comparateur, destiné à transmettre le signal de sortie du dispositif comparateur (30) comme information auxiliaire sur une ligne de données additionnelle (22).

2. Codeur selon la revendication 1, dans lequel le seuil prédéterminé est un rapport prédéterminé entre le nombre de bits avec un premier état logique du mot de données et le deuxième nombre de bits avec un deuxième état logique du mot de données.

3. Codeur selon la revendication 1 ou 2, dans lequel les deux états que peut adopter chaque bit d'un mot de données sont des états logiques complémentaires.

4. Codeur selon l'une des revendications 1 à 3, dans lequel le codeur (16) peut être relié au bus de données (14).

5. Codeur selon l'une des revendications 1 à 4, dans lequel est prévu, pour chaque ligne de bus du bus de données (14), un dispositif pilote (18).

6. Codeur selon l'une des revendications 1 à 5, dans lequel le dispositif destiné à examiner le mot de données est un dispositif comparateur (30) qui compare les états logiques du mot de données.

7. Codeur selon l'une des revendications 1 à 6, dans lequel le codeur (16) présente un dispositif d'inversion (32), pour modifier l'état d'un bit de mot de données.

8. Codeur selon l'une des revendications 1 à 7, dans lequel le codeur (16) peut être relié à une ligne de données (22), pour transmettre les informations auxiliaires.

9. Codeur selon la revendication 8, dans lequel la ligne de données (22) fait partie du bus de données (14).

10. Codeur selon l'une des revendications 1 à 9, dans lequel le codeur (16) fait partie d'un module électrique (10) qui communique avec un module de mémoire (12).

11. Procédé pour coder un mot de données avec une pluralité de bits, pour garantir, lors d'une transmission du mot de données, en ce qui concerne un bruit de commutation synchrone SSN, une évaluation fiable de l'état de chaque bit du mot de données, le mot de données pouvant être transmis en parallèle sur un bus de données (14) avec une pluralité de lignes de bus, pour chaque bit étant prévue une ligne de bus, et chaque bit pouvant adopter l'un de deux états, aux étapes suivantes consistant à :
examiner le mot de données avec un dispositif comparateur, pour constater si un premier nombre de bits avec un premier état logique du mot de données s'écarte d'un deuxième nombre de bits avec un deuxième état logique du mot de données de plus d'un seuil prédéterminé, le seuil prédéterminé étant choisi pour garantir, en cas de descente au-dessous du seuil prédéterminé, une transmission sûre du mot de données en ce qui concerne une évaluation fiable de l'état de chaque bit du mot de données, le dispositif comparateur présentant une sortie de comparateur ;
modifier l'état d'une pluralité de bits du mot de données avec un nombre de dispositifs d'inversion programmables, pour générer un mot de données codé lorsque le mot descend au-dessous du seuil prédéterminé, le nombre de dispositifs d'inversion programmables étant fonction du nombre de lignes de bus, pour modifier un nombre suffisamment grand de bits du mot de données pour réduire ou éviter le bruit de commutation synchrone SSN lors de la transmission du mot de données codé, les dispositifs d'inversion programmables présentant des connexions de commande qui sont reliées à la sortie de comparateur ;
transmettre le signal de sortie du dispositif comparateur avec un pilote de signal (20) qui est relié à la sortie de comparateur, comme information auxiliaire sur une ligne de données additionnelle.

12. Décodeur (28) pour décoder un mot de données codé avec une pljuralité de bits, chaque bit du mot de données pouvant être transmis en parallèle sur une ligne de bus d'un bus de données (14) avec une pluralité de lignes de bus, et chaque bit pouvant adopter l'un de deux états, aux caractéristiques suivantes :
un dispositif destiné à recevoir le mot de données codé du bus de données (14), pour chaque ligne de bus du bus de données (14) étant prévu un pilote de réception (24), et un autre pilote de réception (26) étant, par ailleurs, prévu pour une ligne de données additionnelle, après chacun de pilotes de réception (24) déterminés étant connecté un dispositif d'inversion programmable (34), un nombre de dispositifs d'inversion programmables (34) et une association des dispositifs d'inversion programmables (34) aux lignes de bus correspondant au nombre et à l'association d'inverseurs programmables (32) d'un codeur associé (16), les dispositifs d'inversion programmables présentant des entrées de commande qui sont reliées à la sortie de l'autre pilote de réception (26), pour décoder le mot de données codé conformément au signal transmis comme information auxiliaire sur la ligne de données additionnelle.
